# EUROPEAN PATENT APPLICATION

(11) **EP 4 852 631 A1**
(43) Date of publication of application: **09.12.2026**
(21) Application number: 26180971.9
(22) Date of filing: 26.05.2026
(51) Int. Cl.: H05K 7/14

(54) **INDUSTRIAL UNITS WITH STRUCTURAL PRINTED CIRCUIT BOARDS PROVIDING ELECTRICAL CONNECTIVITY AND MECHANICAL SUPPORT**

(30) Priority: 04.06.2025 US 202519228056
(71) Applicant: Rockwell Automation Technologies, Inc., Mayfield Heights, OH 44124 (US)
(72) Inventor: Peterson, Corey A., Mayfield Heights, OH, 44124 (US); Bellows, Troy M., Mayfield Heights, Ohio, 44124 (US); Ossanna, Mark E., Mayfield Heights, Ohio, 44124 (US); Halpin, Peter J., Mayfield Heights, Ohio, 44124 (US)
(74) Representative: Grünecker Patent- und Rechtsanwälte PartG mbB

(57) **Abstract**

The disclosure describes an industrial automation system with a cabinet having one or more slots configured to receive industrial units. Each industrial unit includes a casing, a structural printed circuit board assembly (PCBA) mounted within the casing, and one or more industrial devices mounted to the structural PCBA. The structural PCBA provides both mechanical support and electrical connectivity for the industrial devices. Device connectors of the industrial devices electrically couple with corresponding PCBA connectors to receive power and communications without external wiring, according to some implementations.

## Description

### TECHNICAL FIELD

This disclosure relates generally to industrial automation systems, and more specifically to structural printed circuit boards for mounting industrial devices within system units.

### BACKGROUND

Industrial manufacturers have increasingly adopted modular designs for automation systems to provide flexible configuration, facilitate easier maintenance, and allow customers to select, replace, or upgrade individual components without reengineering of the entire system. For example, Motor Control Centers (MCCs) are often constructed from a series of modular units, referred to as "buckets." Each bucket houses components including, for example, a motor starter, drive, circuit protection device, or related control equipment and can be quickly installed into, or removed from, an MCC cabinet to facilitate serviceability and scalability. However, while modular architectures streamline final assembly and field maintenance, significant challenges and production bottlenecks exist at the level of manufacturing individual modular units.

Each individual unit may include sub-components (e.g., industrial devices) that must be interconnected to receive power and communication signals. For example, industrial devices in a starter unit may include a contactor, a circuit breaker, and a control device. Distributing power and communication signals among such internal devices presents significant challenges during manufacturing and assembly of the industrial units.

During assembly of these units, a technician typically mounts industrial devices onto a structural surface, such as a steel backplate, and manually wires the devices for power and communication. This manual process is time-consuming, dependent on skilled labor, and prone to assembly errors. After deployment, maintenance is complicated by the dense network of cables, which can make fault diagnosis and repair slow, difficult, and error prone. As demand grows for greater configuration flexibility, faster deployment, and simplified maintenance, existing unit designs increasingly contribute to bottlenecks during production and operation.

### SUMMARY

The present disclosure describes an industrial unit incorporating a structural printed circuit board assembly (PCBA) configured to both mechanically support industrial devices and provide electrical connectivity for the industrial devices. Upon mounting an industrial device to the structural PCBA, the industrial device may receive power through electrical connections integrated within the structural PCBA, thereby reducing or eliminating the need for flexible cables during assembly. As a result, the described system makes manufacturing simpler, faster, and more reliable, alleviating the above-described issues.

One implementation of an industrial automation system disclosed herein includes a cabinet having at least one slot configured to receive an industrial unit. The cabinet further includes one or more electrical buses disposed in the cabinet and supplying power to the industrial unit. The system further includes the industrial unit mounted in the slot. The industrial unit includes a casing with a rear portion having one or more bus connectors configured to removably couple with the one or more electrical buses. The industrial unit further includes a structural printed circuit board assembly (PCBA) mounted in the casing. The structural PCBA is configured to provide mechanical support and electrical connectivity for an industrial device. The structural PCBA includes a rear surface electrically coupled to the one or more bus connectors to receive one or both of power and communications from the one or more electrical buses. The structural PCBA further includes a front surface including one or more PCBA connectors. The industrial device is mounted to the front surface such that the structural PCBA supports a weight of the industrial device. The industrial device includes one or more device connectors electrically coupled with the one or more PCBA connectors.

In some implementations, the industrial device is a first industrial device. The industrial unit further includes a second industrial device mounted to the front surface of the structural PCBA such that the structural PCBA supports a weight of the second industrial device and provides electrical connectivity for the second industrial device. The structural PCBA further includes one or more traces electrically coupling the first industrial device to the second industrial device.

In some implementations, the industrial unit further includes one or more unit busbars extending between the rear surface of the structural PCBA and the rear portion of the casing. The unit busbars are configured to electrically couple the one or more bus connectors to the structural PCBA. The industrial device plugs directly into the structural PCBA to receive one or both of power and communications from the one or more electrical buses via the rigid connectors and the structural PCBA, thereby electrically coupling the industrial device to the one or more electrical buses without flexible cables.

In some implementations, the one or more electrical buses comprise three electrical buses configured to supply three-phase electrical power. The one or more bus connectors include three plug-in connectors each configured to couple to a respective electrical bus of the three electrical buses.

In some implementations, the one or more device connectors are configured to directly contact the front surface of the structural PCBA to electrically couple the industrial device to the one or more PCBA connectors.

In some implementations, the one or more device connectors are electrically coupled to the one or more PCBA connectors via a soldered connection.

In some implementations, the one or more device connectors are electrically coupled to the one or more PCBA connectors via a compression fit connection.

In some implementations, the one or more device connectors are disposed on a lateral side of the industrial device. The industrial device includes one or more rigid bus connectors configured to extend from the one or more device connectors to the one or more PCBA connectors to electrically couple the industrial device to the structural PCBA.

In some implementations, the structural PCBA includes one of: a metal-core PCB, a heavy-copper-plate PCB, and an embedded coined PCB.

In some implementations, the industrial device is removably mounted to the structural PCBA.

In some implementations, the industrial device comprises one of: a contactor, a circuit breaker, a fused disconnect, a relay, motor starter, a motor drive, or a control component.

In some implementations, the industrial automation system includes one of: a Motor Control Center (MCC), a power distribution board, or a load center.

These and other features and aspects of various examples may be understood in view of the following detailed discussion and accompanying drawings.

### BRIEF DESCRIPTION OF THE DRAWINGS

Fig. 1 illustrates an industrial automation system in an implementation.
Figs. 2A and 2B illustrate an industrial unit in an implementation.
Figs. 3A and 3B illustrate another industrial unit in an implementation.
Figs. 4A and 4B illustrate another industrial unit in an implementation.
Fig. 5 illustrates another industrial unit in an implementation.
Fig. 6 illustrates a process for manufacturing an industrial automation system in an implementation.

### DETAILED DESCRIPTION

When manufacturing an industrial automation system, an industrial manufacturer assembles multiple industrial units configured to perform various control and power distribution functions. Each industrial unit typically houses one or more industrial devices, such as motor starters, circuit breakers, fused disconnects, overload relays, or control components, that are mechanically mounted and electrically interconnected. Existing assembly practices often involve securing industrial devices onto a mounting surface, such as a metal backplate, and manually wiring connections to the devices for power and communication. This manual process is time-consuming, labor-intensive, and prone to assembly errors. In environments where customers demand fast delivery schedules, assembly of the individual units can create production bottlenecks. In addition, the volume of wiring within each unit increases the complexity of maintenance activities after deployment. Accordingly, existing designs for industrial units introduce significant challenges in industrial environments.

The disclosure describes automation systems utilizing structural printed circuit board assemblies (PCBAs) to simplify the manufacturing process and improve the assembly, maintenance, and scalability of industrial units. In the described system, a structural PCBA provides both mechanical support for industrial devices and integrated electrical connectivity for the devices.

The industrial automation system may include a cabinet housing one or more electrical buses configured to distribute power and / or network communication signals to modular industrial units. The cabinet may include multiple slots or compartments, each slot configured to receive and retain a corresponding industrial unit. Each industrial unit may be removably coupled to the electrical buses via one or more bus connectors (e.g., plug-in stab connectors) disposed at a rear portion of the unit. As one example, a motor control center (MCC) may employ such a modular configuration, where motor starters, drives, relays, circuit breakers, fused disconnects, and other industrial devices are assembled into standardized units ("buckets") that are inserted into cabinet slots and electrically coupled to the electrical buses.

In the described system, one or more industrial devices are mounted directly to structural printed circuit board assemblies (PCBAs) disposed within the industrial units. Each structural PCBA is configured to support the weight of the mounted industrial devices (noting that the industrial devices may extend laterally from the surface of the structural PCBA when installed). Further, the structural PCBAs are configured to supply electrical power directly to the mounted industrial devices without the use of external or additional wiring. For example, the structural PCBAs may be electrically coupled to the electrical buses of the cabinet, and distribute the received power and / or network communication signals to the industrial devices through internal connectors and integrated electrical traces formed in the structural PCBAs.

Accordingly, when assembling an industrial unit, a technician may simply mount the industrial devices onto the structural PCBA without separately wiring the devices for power distribution. This architecture improves the efficiency of manufacturing industrial automation systems by reducing assembly time and labor costs. In addition, the system increases assembly consistency and reduces the likelihood of wiring errors. Specifically, the locations of electrical connectors on the structural PCBA may be standardized, eliminating the need for manual connection decisions during assembly or maintenance. For example, when replacing an industrial device within a unit, a technician may dismount the existing device from the structural PCBA and mount the replacement device directly in its place without additional wiring or reconfiguration.

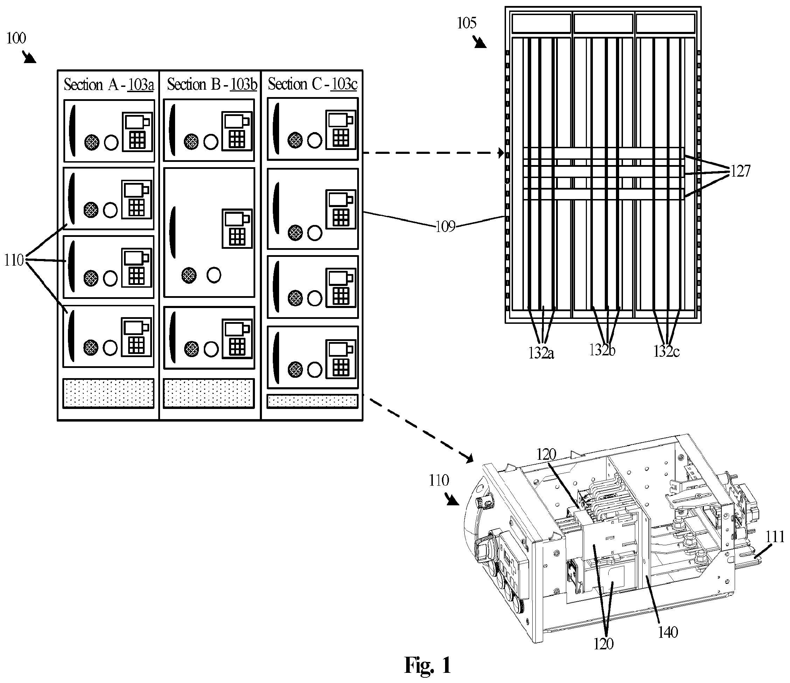

**Fig. 1** illustrates industrial automation system 100 according to some implementations. Industrial automation system 100 is a system configured to perform functions in an industrial automation environment, such as control, monitoring, and power distribution. Industrial automation system 100 may include cabinet 109 configured to house multiple industrial units 110. In addition to physically supporting industrial units 110, industrial automation system 100 provides electrical power and communication links to industrial devices mounted within the industrial units 110. In certain implementations, industrial automation system 100 may be a motor control center (MCC) housing industrial units such as motor drive units, motor starter units, or similar equipment. It should be noted that the concepts described herein are not limited to MCCs; in various embodiments, the industrial automation system 100 may alternatively be implemented as a power distribution board, load center, or another type of industrial system.

Industrial automation system 100 may include multiple sections 103a, 103b, and 103c (collectively, sections 103), each having a vertical column defining multiple slots sized to receive corresponding industrial units 110. Industrial automation system 100 may be modular, allowing operators to design and purchase systems with a desired number and arrangement of sections 103, to accommodate specific combinations of industrial units 110 for particular applications.

Cabinet interior 105 represents an interior view of the industrial automation system 100, illustrated without the industrial units 110 for clarity. Cabinet interior 105 includes horizontal electrical buses 127 and vertical electrical buses 132a, 132b, and 132c (collectively referred to as vertical electrical buses 132). Horizontal electrical buses 127 extend laterally across cabinet interior 105 and are configured to distribute three-phase electrical power (and/or communication signals) to vertical electrical buses 132. Vertical electrical buses 132 extend vertically through cabinet interior 105 and are configured to supply electrical power (and / or communication signals) to industrial units 110 mounted within the industrial automation system 100. For example, vertical electrical buses 132a may distribute electrical power to industrial units 110 installed in first section 103a, vertical electrical buses 132b may distribute power to industrial units 110 installed in second section 103b, and so forth. While vertical and horizonal electrical buses are illustrated in Fig. 1, it should be noted that the electrical buses in cabinet interior 105 may have various other orientations in different implementations.

Horizontal electrical buses 127 may receive three-phase power from an external power distribution network and distribute the power among the various vertical electrical buses 132. Each industrial unit 110 may include one or more bus connectors 111 (e.g., plug-in stab connectors) configured to electrically couple to the respective vertical electrical buses 132 to supply power to internal components of industrial units 110. In some implementations, horizontal electrical buses 127 and vertical electrical buses 132 may additionally or alternatively include communication busbars configured to transmit control signals or communication data to industrial units 110.

Industrial unit 110 is representative of a modular unit installed in a slot of industrial automation system 100. Industrial unit 110 may include various components, such as motor drive units, motor starter units, among various other types of units. It should be noted that industrial unit 110 and the internal components described here may be representative of industrial units described in the subsequent figures.

Industrial unit 110 includes bus connectors 111 to couple to vertical electrical buses 132, as noted above. Industrial unit 110 may be installed in industrial automation system 100 by sliding industrial unit into a slot of industrial automation system such that bus connectors 111 engage or plug onto vertical electrical buses 132.

Industrial unit 110 includes structural PCBA 140 electrically coupled to bus connectors 111 to receive electrical power from vertical electrical buses 132. Industrial unit 110 further includes one or more industrial devices 120 mounted onto structural PCBA 140. Industrial devices 120 may include various types of industrial equipment, such as circuit breakers, fused disconnects relays, contactors, control components, and similar devices. Industrial devices 120 perform the control and/or power distribution functions of industrial unit 110. For example, where industrial unit 110 is configured as a motor starter unit, industrial devices 120 may include a relay, a circuit breaker, and a contactor. In general, industrial devices 120 may include various different types of devices, including (but not limited to): contactors, circuit breakers, fused disconnects, relays, motor starters, motor drives, and control components.

Structural PCBA 140 is configured to distribute electrical power and /or network communication signals (including network communication signals) to industrial devices 120. In addition to providing electrical connectivity, structural PCBA 140 mechanically supports the weight of industrial devices 120 mounted thereon. Industrial devices 120 may vary in weight, for example, between approximately two pounds and approximately twenty pounds. Accordingly, structural PCBA 140 may be reinforced, by selection of board thickness, materials, or support structures, to provide sufficient mechanical strength to support the mounted industrial devices 120 without the use of a separate steel backplate.

In various implementations, structural PCBA 140 may be formed as a metal-core printed circuit board (e.g., incorporating a metal-core base material such as copper-clad Invar or aluminum to improve thermal performance and current-carrying capacity), a heavy-copper printed circuit board, or an embedded coined printed circuit board (i.e., incorporating thick embedded copper plugs or coined copper inserts to enhance heat dissipation and electrical robustness). Additionally, structural PCBA 140 may include thermal management features such as a "ring of vias" surrounding high-power regions to facilitate heat conduction, or oversized via holes filled with thermally conductive material to assist with heat dissipation and containment of energy during a short-circuit event.

The inclusion of structural PCBA 140 improves the speed, accuracy, and ease of manufacturing industrial unit 110. In particular, a technician may mount industrial devices 120 onto structural PCBA 140 using mechanical fasteners, such as screws, or nuts and bolts. Structural PCBA 140 provides both mechanical support and integrated electrical and communication connectivity for industrial devices 120, thereby eliminating the need for individual manual wiring operations for power and communication.

In some implementations, structural PCBA 140 may be configured with standardized mounting locations and electrical connectors, enabling different types or sizes of industrial devices 120 to be interchangeably mounted onto structural PCBA 140 without modifications to structural PCBA 140 or additional wiring operations. This modular configuration allows manufacturers and operators to readily customize industrial units 110 by selecting appropriate industrial devices 120 based on application requirements, while maintaining a consistent and streamlined manufacturing and maintenance process.

Industrial unit 110 may be implemented in various configurations, as described in greater detail with reference to the subsequent figures. Unless otherwise noted, the description of industrial unit 110 and its associated components is applicable to industrial units 210, 310, 410, and 510 described below.

While the implementation in Fig. 1 illustrates industrial unit 110 as part of industrial automation system 100, it should be noted that in some implementations, industrial unit 110 (as well as industrial units 210, 310, 410, and 510 of subsequent figures) may be a stand-alone unit. In such stand-alone configurations, industrial unit 110 may not be physically coupled to a centralized cabinet or shared bus infrastructure. Instead, industrial unit 110 may operate as an independent unit capable of receiving power and communication signals from external sources (e.g., via wired connections to a panel) without being inserted into a slot of a cabinet. The standalone industrial unit may have substantially similar functional advantages as cabinet-based implementation discussed herein, including the use of a structural PCBA to mechanically support and electrically interconnect industrial devices mounted within the casing. Further, while such standalone units may have wired connections from the exterior of the unit to connect to an external panel, for example, the interior of the unit may reduce wiring by use of the structural PCBA, as described herein.

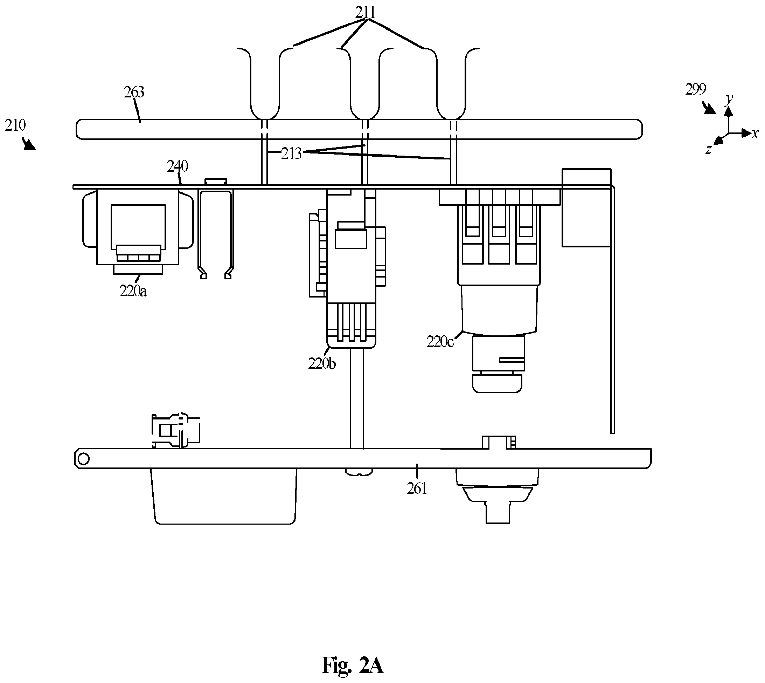

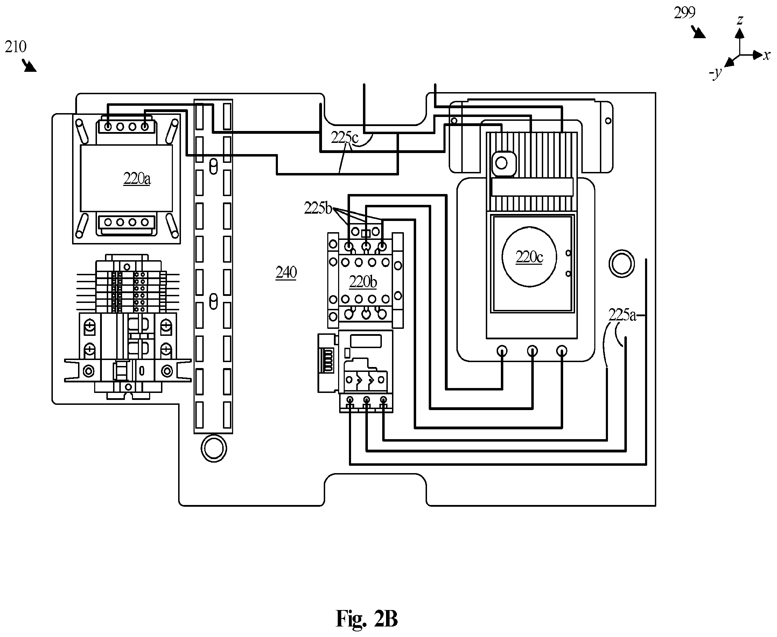

**Figs. 2A** **and** **2B** illustrate industrial unit 210. Fig. 2A shows a top-down view of industrial unit 210, while Figure 2B provides a front-facing view of the interior of industrial unit 210 (for example, as seen when opening the unit's front panel 261). The orientation of the views is indicated by coordinates 299, where z indicates a vertical direction (e.g., substantially parallel to the force of gravity). Industrial unit 210 may correspond to industrial unit 110 shown in Figure 1.

Starting with Fig. 2A, industrial unit 210 includes front panel 261, which may include interface components such as indicator lights, switches, or other operator-accessible elements. Front panel 261 may be configured to open to provide access to internal components of industrial unit 210. Industrial unit 210 further includes back panel 263. Bus connectors 211 (e.g., plug-in stab connectors) extend from back panel 263 and are configured to electrically couple to cabinet busbars of an industrial automation system, such as vertical electrical buses 132 illustrated in Fig. 1. Bus connectors 211 receive electrical power and/or communication signals from these busbars. In some implementations, industrial unit 210 may include additional mounting features, such as standoffs or mounting rails, which are not illustrated in Fig. 2A for clarity.

Front panel 261 and back panel 263 form at least part of a casing (e.g., housing) of industrial unit 210. The casing may further include side panels and top and bottom panels not illustrated in Fig. 2A for clarity. In general, the casing at least partially surrounds interior components such as structural PCBA 240 and industrial devices 220a, 220b, 220c to provide environmental isolation and physical protection.

Industrial unit 210 further includes unit busbars 213. Unit busbars 213 may be rigid conductive elements configured to transfer electrical power and/or communication signals from bus connectors 211 to a rear surface of structural PCBA 240. Unit busbars 213 are electrically coupled to structural PCBA 240 to provide power and/or communication signals to structural PCBA 240.

Structural PCBA 240 represents a printed circuit board assembly configured to mechanically support industrial devices 220a, 220b, 220c (collectively, industrial devices 220) and to distribute electrical power and/or communication signals to industrial devices 220. Structural PCBA 240 may be substantially similar to structural PCBA 240 described above with reference to Fig. 1. Structural PCBA 240 may include traces that electrically interconnect industrial devices 220a, 220b, 220c, as described further below.

Continuing with Fig. 2B, structural PCBA 240 includes traces 225a, 225b, and 225c (collectively referred to as traces 225) that electrically interconnect various industrial devices 220 mounted on structural PCBA 240. Traces 225 are electrically conductive paths formed in structural PCBA 240. Traces 225 may be fabricated from a layer of conductive material, such as copper. Traces 225 are configured to distribute electrical signals or power between industrial devices mounted on structural PCBA 240.

As an example, where industrial unit 210 is configured as a motor starter unit, industrial device 220b may represent a contactor and overload relay, industrial device 220c may represent a circuit breaker, and industrial device 220a may represent a transformer. Traces 225 are integrated into structural PCBA 240 and are configured to distribute electrical power and / or network communication signals among the mounted industrial devices 220 without external wiring or flexible cables between devices. In this example, unit busbars 213 supply electrical power to industrial device 220c via structural PCBA 240. Industrial device 220c (the circuit breaker) is configured to distribute electrical power separately to industrial device 220a (the transformer) and industrial device 220b (the contactor and overload relay) using respective integrated traces 225b and 225c. Trace 225a electrically couples industrial device 220c to industrial device 220a, and trace 225b electrically couples industrial device 220c to industrial device 220b. Industrial device 220b further includes an output electrically coupled to trace 225a, which may be configured to route electrical power to an external load, such as an industrial motor. In this manner, structural PCBA 240 provides integrated electrical connectivity between industrial devices 220 without separate external wiring or flexible cables.

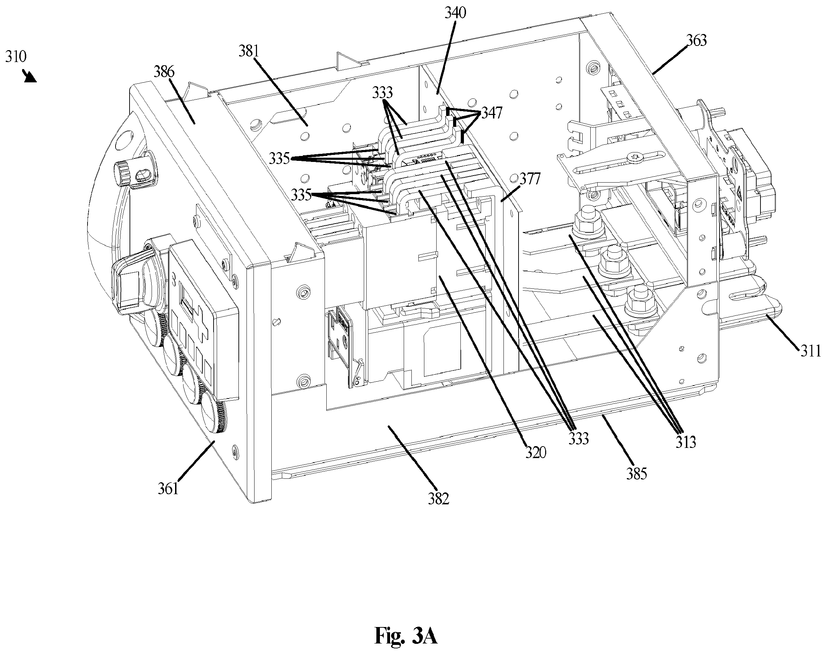

**Figs. 3A** illustrates industrial unit 310 according to some implementations. Industrial unit 310 may be substantially similar to industrial unit 110 described above with reference to Fig. 1, except as otherwise noted. Fig. 3A illustrates the utilization of device busbars 333 to provide electrical connectivity between industrial devices 320 and structural PCBA 340. This configuration enables integration of off-the-shelf industrial devices 320 (i.e., industrial devices 320 used in systems that utilize external flexible cables) with structural PCBA 340, allowing mechanical mounting and electrical connectivity (including, e.g., power connectivity and/or network communication connectivity) to be achieved without redesign of the industrial devices or use of flexible cables or manual wiring.

Industrial unit 310 includes structural PCBA 340, which may be substantially similar to structural PCBA 140, except as otherwise noted. Structural PCBA 340 provides both mechanical support and electrical connectivity (including, e.g., power connectivity and/or network communication connectivity) for industrial devices 320. In industrial unit 310, structural PCBA 340 includes PCBA connectors 347 positioned to establish electrical connections with device busbars 333 extending toward the mounted industrial devices 320. Device busbars 333 transfer electrical power and, in some implementations, communication signals from PCBA connectors 347 to corresponding industrial devices 320. Device busbars 333 may be formed from rigid conductive materials, such as copper, copper alloys, or plated metals, to provide high current-carrying capacity and mechanical stability.

Each industrial device 320 includes one or more device connectors 335 disposed on a lateral side of the device and configured to receive the corresponding device busbars 333. Device connectors 335 may be implemented as electrical sockets or receptacles configured to secure and electrically couple to the inserted device busbars 333. PCBA connectors 347 may include, for example, copper contact leads that mechanically and electrically engage the device busbars 333. In some implementations, a compression fit may be utilized to establish electrical coupling between the device busbars 333 and the PCBA connectors 347, while in other implementations, the connection may be established via flash soldering or mechanical fastening. This configuration enables industrial devices 320 to establish robust mechanical and electrical connections to structural PCBA 340 without external wiring (i.e., flexible cables) between devices and the board. Specifically, unlike typical external wiring, which includes flexible cables manually routed and secured during assembly, device busbars 333 provide rigid, pre-aligned conductive paths that mechanically and electrically couple industrial devices 320 to structural PCBA 340.

In some implementations, industrial unit 310 may further include one or more busbar holders 377 configured to provide mechanical support and electrical insulation for device busbars 333. Busbar holders 377 may be disposed between the rear side of industrial device 320 and structural PCBA 340, and may be formed from electrically insulative materials. Busbar holders 377 physically support device busbars 333 and maintain alignment between the device connectors 335 and PCBA connectors 347.

Unit connectors 311 extend from a rear panel 363 of industrial unit 310 and are configured to engage corresponding electrical buses within an industrial automation cabinet, such as vertical electrical buses 132 described above in relation to Fig. 1. Industrial unit 310 further includes unit busbars 313 that electrically couple bus connectors 311 to a rear surface of structural PCBA 340. Structural PCBA 340 may include traces to provide electrical communication (including, e.g., electrical power supply and network communication) from unit busbars 313 to PCBA connectors 347. Accordingly, unit busbars 313 electrically couple bus connectors 311 to structural PCBA 340, while device busbars 333 electrically couple industrial devices 320 to structural PCBA 340.

Industrial unit 310 further includes a front panel 361, which may support user interface elements, such as indicators, switches, and connectors. Industrial unit 310 may also include side panels 381, 382, bottom panel 385, and top panel 386 (cutaway in Fig. 3A to illustrate the interior of industrial unit 110) surrounding or partially surrounding internal components such as structural PCBA 340 and industrial devices 320 for protection and structural reinforcement. Front panel 361, rear panel 363, side panels 381, 382, bottom panel 385, and top panel 386 together form at least part of a casing (e.g., housing) for industrial unit 310.

In general, the casing (i.e., front panel 361, rear panel 363, side panels 381, 382, bottom panel 385, and top panel 386) surrounds and protects internal elements, such as structural PCBA 340 and industrial devices 320. Structural PCBA 340 may be mounted between side panels 381, 382 according to some implementations. For example, edge portions of structural PCBA 340 may be secured to side panels 381, 382 via mechanical mounting means such as screws, nuts and bolts, grooves, or other mechanical mounting means. Structural PCBA 340 may additionally or alternatively be secured to bottom panel 385 and/or top panel 386 in various implementations.

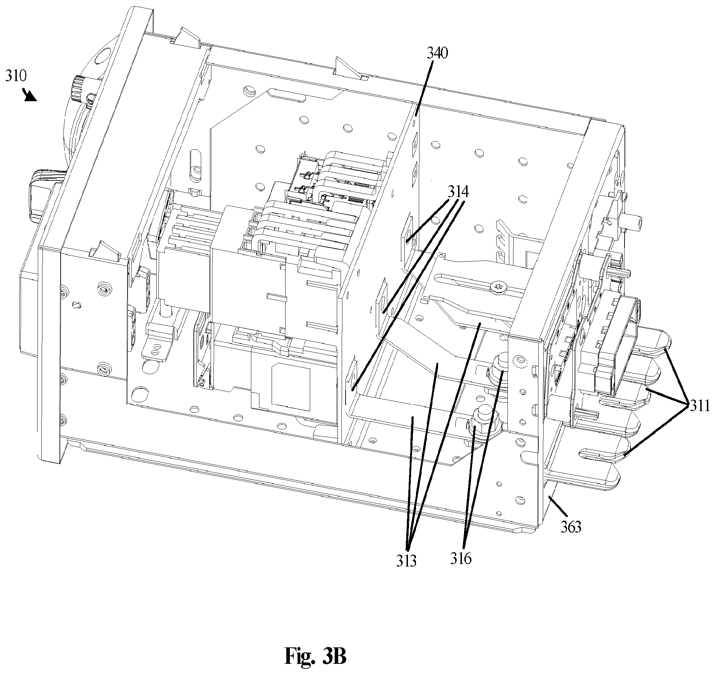

**Fig. 3B** illustrates a rear perspective view of industrial unit 310 according to some implementations. Various components of industrial unit 310 are discussed above in relation to Fig. 3A; accordingly, repeated descriptions are omitted here for clarity and brevity. Fig. 3B highlights the structural and electrical configuration of the unit connectors 311 and unit busbars 313 providing electrical connectivity between the industrial automation system and structural PCBA 340.

As shown in Fig. 3B, unit connectors 311 are disposed on rear panel 363 of industrial unit 310 and are configured to mate with corresponding electrical buses of an industrial automation system (e.g., vertical electrical buses 132 of Fig. 1). Unit busbars 313 are electrically coupled to unit connectors 311 (e.g., via internal conductive paths through rear panel, and via bolted connections 316). Unit busbars 313 extend from rear panel 363 through the interior of industrial unit 310, terminating at contacting ends 314 that engage corresponding electrical connectors on the rear surface of structural PCBA 340. In various implementations, contacting ends 314 may be mechanically and electrically coupled to structural PCBA 340 via compression fits, mechanical fasteners, or soldered connections. The rigid, pre-aligned configuration of unit busbars 313 facilitates rapid and reliable electrical coupling between the cabinet power infrastructure and structural PCBA 340, reducing the need for flexible cabling and minimizing complexity of assembly.

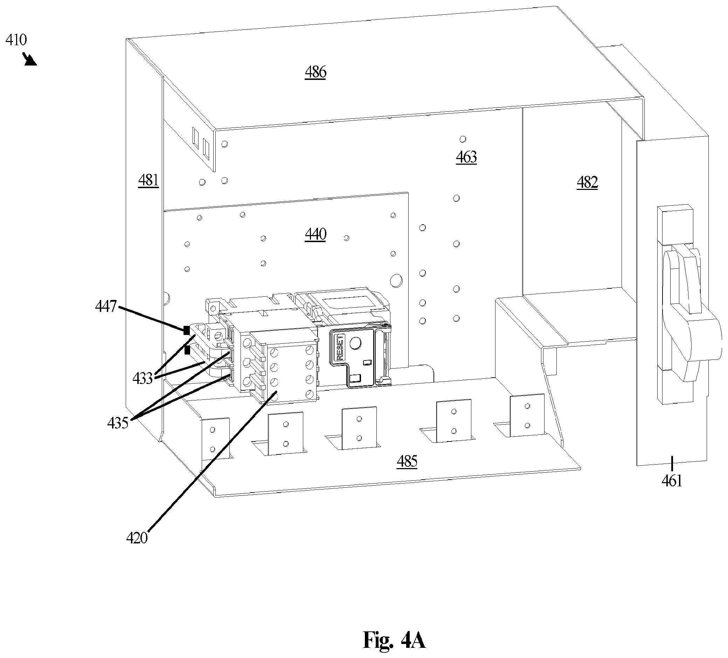

**Fig. 4A** illustrates industrial unit 410 according to some implementations. Industrial unit 410 may be similar to industrial unit 110 of Fig. 1, except as otherwise noted. In the embodiment shown in Fig. 4A, structural PCBA 440 is mounted against a back panel 463 of industrial unit 410, rather than being mounted between the front and rear of the unit as in previous examples. Mounting structural PCBA 440 to back panel 463 provides additional mechanical rigidity and protection for the structural PCBA 440 while maintaining integrated mechanical mounting and electrical connectivity for the industrial devices 420. Structural PCBA 440 may be mounted to back panel 463 using various attachment means, such as screws, nuts and bolts, and the like.

Industrial unit 410 includes industrial device 420 mounted to structural PCBA 440. It is noted that, while one industrial device 420 is illustrated for clarity, industrial unit 410 may include multiple industrial devices 420 mounted to structural PCBA 440.

Industrial device 420 includes device busbars 433 electrically coupling industrial device 420 to PCBA connectors 447. Industrial device 420 includes one or more device connectors 435 disposed on a lateral side of industrial device 420 and configured to receive the corresponding device busbars 433. Device connectors 435 may be implemented as electrical sockets or receptacles configured to secure and electrically couple to the inserted device busbars 433. PCBA connectors 447 may include, for example, copper contact leads that mechanically and electrically engage the device busbars 433. Structural PCBA 440 may include integrated electrical traces to distribute electrical power received from external sources to the attached industrial device 420. Accordingly, the use of structural PCBA 440 reduces the need for extensive manual wiring and flexible cables within industrial unit 410, reducing assembly time, increasing reliability, and simplifying maintenance operations.

Industrial unit 410 further includes front panel 461 supporting mechanical and user-interface features, such as actuators, switches, or indicators, for user interaction with the internal devices. Industrial unit 410 further includes side panels 481, 482, bottom panel 485, and top panel 486. Together, side panels 481, 482, bottom panel 485, top panel 486 and back panel 463 form a casing (e.g., housing) of industrial unit 410 to at least partially surround interior components such as industrial device 420 and structural PCBA 440. The casing provides physical protection and access control for the interior components.

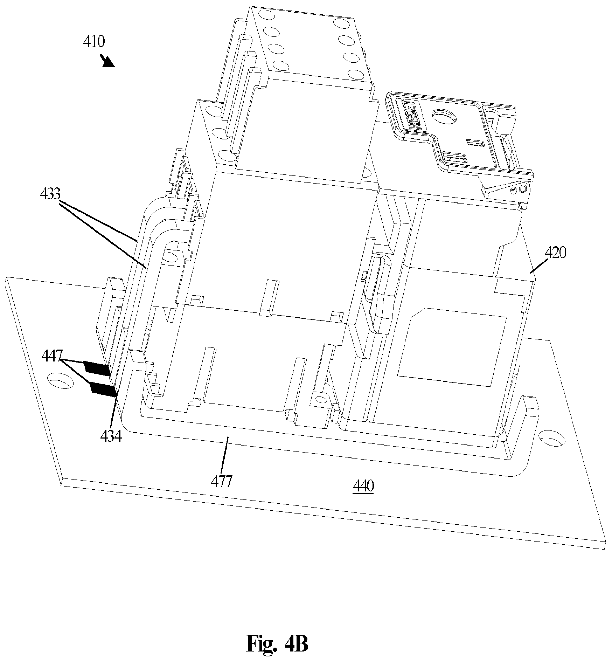

**Fig. 4B** illustrates a zoomed-in view of structural PCBA 440 and industrial device 420 of industrial unit 410. As shown, device busbars 433 extend from industrial device 420 to PCBA connectors 447 disposed on the front surface of structural PCBA 440. Each device busbar 433 includes an end portion 434 configured to electrically contact a corresponding PCBA connector 447.

In some implementations, PCBA connectors 447 may be implemented as contactor strips, conductive pads, or embedded terminal blocks integrated into structural PCBA 440. End portions 434 of device busbars 433 may be electrically coupled to PCBA connectors 447 using various techniques, including compression fitting, flash soldering, or mechanical fastening. For example, in a compression fit embodiment, end portions 434 may be dimensioned to press securely against the contactor strips of PCBA connectors 447, establishing robust electrical contact. The use of contactor strips or similar connection structures for PCBA connectors 447 provides adaptability by allowing industrial devices 420 of different types, sizes, or electrical configurations to be easily mounted and electrically coupled to structural PCBA 440 without redesigning the board layout or requiring custom wiring for each device configuration.

In some implementations, industrial unit 410 may further include one or more busbar holders 477 configured to provide mechanical support and electrical insulation for device busbars 433. Busbar holders 477 may be disposed between the rear side of industrial device 420 and structural PCBA 440, and may be formed from electrically insulative materials. Busbar holders 477 physically support device busbars 433 and maintain alignment between the device connectors 435 and PCBA connectors 447.

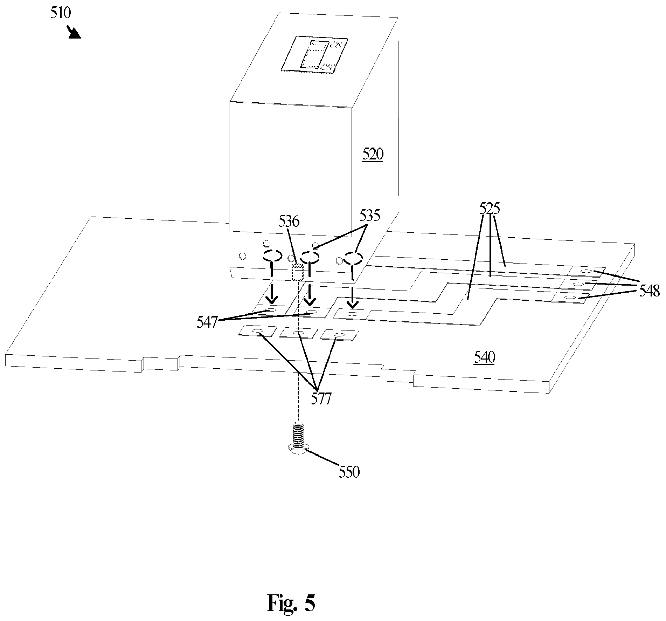

**Fig. 5** illustrates industrial unit 510 according to some implementations. Industrial unit 510 may be similar to industrial unit 110 of Fig. 1, except as otherwise noted. In Fig. 5, industrial device 520 is configured with device connectors 535 disposed on a rear portion of industrial device 520 (i.e., on the face of industrial device 520 contacting structural PCBA 540) to directly engage PCBA connectors 547 of structural PCBA 540. Device connectors 535 are illustrated in dashed lines to represent their position relative to structural PCBA 540, as they would otherwise be obscured from view. It is noted that, while one industrial device 520 is illustrated for clarity, industrial unit 510 may include multiple industrial devices 520 mounted to structural PCBA 540.

Structural PCBA 540 may be mounted within industrial unit 510 and provides both mechanical support and electrical connectivity for industrial devices 520. In the illustrated example, industrial device 520 is mounted onto structural PCBA 540, with device connectors aligned to electrically couple with PCBA connectors 547. PCBA connectors 547 may include conductive contact strips, solder pads, or embedded terminals configured to receive the corresponding device connectors of industrial device 520. Electrical coupling between PCBA connectors 547 and the device connectors may be achieved via compression fit, soldering, flash soldering, or mechanical fastening techniques.

In addition to PCBA connectors 547, structural PCBA 540 includes traces 525 configured to route electrical power and/or communication signals across the surface and /or between layers of structural PCBA 540. Traces 525 may be connected to additional PCBA connectors 548 disposed on an opposite side of PCBA 540 relative to PCBA connectors 547. PCBA connectors 548 may be configured to couple structural PCBA 540 to additional industrial devices or to external power sources, enabling daisy-chaining or multi-stage power distribution across multiple components.

Structural PCBA 540 further includes mounting holes 577 aligned with mounting features 536 of industrial device 520. These mounting features 536 may be disposed on a rear surface of industrial device 520 (i.e., on the face of industrial device 520 contacting structural PCBA 540). Mounting features 536 may include, for example, threaded holes, threaded inserts, or other fastening features configured to receive fasteners 550. Mounting feature 536 is illustrated in grey to represent an internal component extending to the rear surface, since the mounting feature would otherwise be obscured from view. It should be noted that while one mounting feature 536 is illustrated in Fig. 5 for clarity, various implementations may include one or more mounting features 536 (e.g., one mounting feature 536 for each corresponding mounting hole 577).

Industrial device 520 may be mechanically secured to structural PCBA 540 using fasteners 550, such as screws, bolts, or other mechanical fastening devices, providing structural stability for the mounted device. While one faster 550 is illustrated in Fig. 5 for clarity, it should be noted that one or more fasters may in various implementations (e.g., one faster 550 for each mounting hole 557).

Accordingly industrial device 520 may be mounted directly to structural PCBA 540 without intermediate support structures, such as busbar holders, insulative standoffs, or separate mounting brackets. This direct-mount architecture simplifies assembly and reduces the number of parts. Additionally, the absence of separate busbar holders or support structures reduces the overall volume and complexity of the unit.

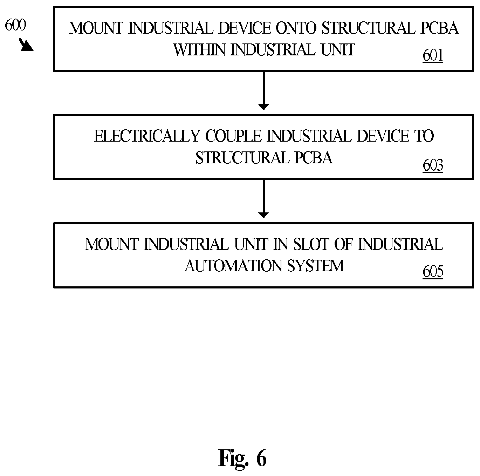

**Fig. 6** illustrates a process for manufacturing industrial automation systems, illustrated as process 600. Process 600 is discussed in the context of industrial automation system 100 of Fig. 1. The steps of process 600 may be performed by a human or a machine in various implementations.

Step 601 is mounting industrial device 120 onto a structural PCBA 140 within industrial unit 110. The mounting operation may involve physically securing the industrial device 120 onto the front surface of the structural PCBA 140 using mechanical fasteners, such as screws, bolts, or other fastening techniques. The mounting procedure ensures that the structural PCBA 140 provides mechanical support for the weight and vibration loads associated with the industrial device 120, while also aligning the device connectors for electrical coupling.

Step 603 is electrically coupling industrial device 120 to structural PCBA 140. In some implementations, the device connectors may directly contact PCBA connectors through compression fitting, soldering, mechanical locking, or other joining techniques (as illustrated by way of example in Fig. 5). In alternative implementations, rigid busbars may extend from the device to the PCBA connectors to achieve electrical coupling (as illustrated by way of example in Figs. 3A, 3B, 4A, and 4B). In either case, electrical power and/or communication signals are routed via internal traces within the structural PCBA 140, thereby eliminating the need for separate external wiring between the device and the board.

Step 605 is mounting industrial unit 110 into a slot of the industrial automation system 100. This operation may involve sliding the industrial unit 110 into a corresponding compartment or slot within the cabinet of industrial automation system 100 such that one or more unit connectors (e.g., stab connectors) electrically engage corresponding power and/or communication busbars within the cabinet. This modular connection architecture enables rapid installation, flexible configuration changes, and simplified maintenance compared to traditional industrial system designs requiring extensive manual wiring.

However, it should be noted that in some implementations, industrial unit 110 may be a stand-alone unit that is not physically coupled to a cabinet-based industrial automation system, as discussed above in the discussion of Fig. 1. In such implementations, process 600 may not include steps 601 and 603 without the slot insertion of step 605.

It should be noted that the various features and structures described with respect to the industrial units illustrated in the above embodiments (e.g., structural PCBAs, device busbars, PCBA connectors, unit busbars, device connectors, mounting techniques, and thermal management features) may be combined, substituted, or adapted across different implementations. For example, a structural PCBA mounted to a rear panel, as shown in Fig. 4A, may be used in combination with device busbar arrangements illustrated in Fig. 3A, or with rear-mounted device connectors as shown in Fig. 5. Such variations are considered within the scope of this disclosure unless otherwise expressly limited.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number, respectively. The word "or," in reference to a list of two or more items, covers all of the following interpretations of the word: any of the items in the list, all of the items in the list, and any combination of the items in the list.

The phrases "in some embodiments," "according to some embodiments," "in the embodiments shown," "in other embodiments," "in an implementation," "in some implementations," and the like generally mean the particular feature, structure, or characteristic following the phrase is included in at least one implementation of the present technology, and may be included in more than one implementation. In addition, such phrases do not necessarily refer to the same embodiments or different embodiments.

The above Detailed Description of examples of the technology is not intended to be exhaustive or to limit the technology to the precise form disclosed above. While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or subcombinations. Each of these processes or blocks may be implemented in a variety of different ways. Also, while processes or blocks are at times shown as being performed in series, these processes or blocks may instead be performed or implemented in parallel, or may be performed at different times. Further any specific numbers noted herein are only examples: alternative implementations may employ differing values or ranges.

The teachings of the technology provided herein can be applied to other systems, not necessarily the system described above. The elements and acts of the various examples described above can be combined to provide further implementations of the technology. Some alternative implementations of the technology may include not only additional elements to those implementations noted above, but also may include fewer elements.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a means-plus-function claim. Any claims intended to be treated under 35 U.S.C. § 112(f) will begin with the words "means for", but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.
The following is a list of further preferred embodiments of the invention:
1. An industrial automation system comprising:
   a cabinet having at least one slot configured to receive an industrial unit;
   one or more electrical buses disposed in the cabinet and configured to supply one or both of power and communications to the industrial unit;
   the industrial unit configured to mount in the slot, the industrial unit comprising:
      a casing comprising a rear portion having one or more bus connectors configured to removably couple with the one or more electrical buses;
      a structural printed circuit board assembly (PCBA) mounted in the casing, wherein the structural PCBA is configured to provide mechanical support and electrical connectivity for an industrial device, the structural PCBA comprising:
         a rear surface electrically coupled to the one or more bus connectors to receive one or both of power and communications from the one or more electrical buses;
         a front surface comprising one or more PCBA connectors; and
      the industrial device mounted to the front surface such that the structural PCBA supports a weight of the industrial device, the industrial device comprising one or more device connectors electrically coupled with the one or more PCBA connectors.
2. The industrial automation system of embodiment 1, wherein:
   the industrial device is a first industrial device;
   the industrial unit further comprises a second industrial device mounted to the front surface of the structural PCBA such that the structural PCBA supports a weight of the second industrial device and provides electrical connectivity for the second industrial device; and
   the structural PCBA further includes one or more traces electrically coupling the first industrial device to the second industrial device.
3. The industrial automation system of embodiment 1, wherein:
   the industrial unit further comprises:
      one or more unit busbars extending between the rear surface of the structural PCBA and the rear portion of the casing, the one or more unit busbars configured to electrically couple the one or more bus connectors to the structural PCBA; and
   the industrial device plugs directly into the structural PCBA to receive one or both of power and communications from the one or more electrical buses via the one or more unit busbars and the structural PCBA, thereby electrically coupling the industrial device to the one or more electrical buses without flexible cables.
4. The industrial automation system of embodiment 1, wherein:
   the one or more electrical buses comprise three electrical buses configured to supply three-phase electrical power; and
   the one or more bus connectors comprise three plug-in connectors each configured to couple to a respective electrical bus of the three electrical buses.
5. The industrial automation system of embodiment 1, wherein the one or more device connectors are configured to directly contact the front surface of the structural PCBA to electrically couple the industrial device to the one or more PCBA connectors.
6. The industrial automation system of embodiment 5, wherein the one or more device connectors are electrically coupled to the one or more PCBA connectors via a soldered connection.
7. The industrial automation system of embodiment 5, wherein the one or more device connectors are electrically coupled to the one or more PCBA connectors via a compression fit connection.
8. The industrial automation system of embodiment 1, wherein:
   the one or more device connectors are disposed on a lateral side of the industrial device; and
   the industrial device comprises one or more device busbars configured to extend from the one or more device connectors to the one or more PCBA connectors to electrically couple the industrial device to the structural PCBA.
9. The industrial automation system of embodiment 1, wherein the structural PCBA comprises one of: a metal-core PCB, a heavy-copper-plate PCB, and an embedded coined PCB.
10. The industrial automation system of embodiment 1, wherein the industrial device is removably mounted to the structural PCBA.
11. The industrial automation system of embodiment 1, wherein the industrial device comprises one of: a contactor, a circuit breaker, a fused disconnect, a relay, motor starter, a motor drive, or a control component.
12. The industrial automation system of embodiment 1, wherein the industrial automation system comprises one of: a Motor Control Center (MCC), a power distribution board, or a load center.
13. An industrial unit configured to removably couple within an industrial control system cabinet, the industrial unit comprising:
   a casing comprising a rear portion having one or more bus connectors configured to removably couple with one or more electrical buses of the industrial control system cabinet;
   a structural printed circuit board assembly (PCBA) mounted in the casing, wherein the structural PCBA is configured to provide mechanical support and electrical connectivity for an industrial device, the structural PCBA comprising:
      a rear surface electrically coupled to the one or more bus connectors to receive one or both of power and communications from the one or more electrical buses;
      a front surface comprising one or more PCBA connectors; and
   the industrial device mounted to the front surface such that the structural PCBA supports a weight of the industrial device, the industrial device comprising one or more device connectors electrically coupled with the one or more PCBA connectors.
14. The industrial unit of embodiment 13, further comprising:
   one or more unit busbars extending between the rear surface of the structural PCBA and the rear portion of the casing, the one or more unit busbars configured to electrically couple the one or more bus connectors to the structural PCBA, wherein:
   the industrial device plugs directly into the structural PCBA to receive one or both of power and communications from the one or more electrical buses via the one or more unit busbars and the structural PCBA, thereby electrically coupling the industrial device to the one or more electrical buses without flexible cables.
15. The industrial unit of embodiment 13, wherein the one or more device connectors are configured to directly contact the front surface of the structural PCBA to electrically couple the industrial device to the one or more PCBA connectors.
16. The industrial unit of embodiment 15, wherein the one or more device connectors are electrically coupled to the one or more PCBA connectors via a soldered connection.
17. The industrial unit of embodiment 15, wherein the one or more device connectors are electrically coupled to the one or more PCBA connectors via a compression fit connection.
18. The industrial unit of embodiment 13, wherein:
   the one or more device connectors are disposed on a lateral side of the industrial device; and
   the industrial device comprises one or more device busbars configured to extend from the one or more device connectors to the one or more PCBA connectors to electrically couple the industrial device to the structural PCBA.
19. The industrial unit of embodiment 13, wherein the structural PCBA comprises one of: a metal-core PCB, a heavy-copper-plate PCB, and an embedded coined PCB.
20. The industrial unit of embodiment 13, wherein the industrial device is removably mounted to the structural PCBA.

## Claims

1. An industrial automation system comprising:
a cabinet having at least one slot configured to receive an industrial unit;
one or more electrical buses disposed in the cabinet and configured to supply one or both of power and communications to the industrial unit;
the industrial unit configured to mount in the slot, the industrial unit comprising:
a casing comprising a rear portion having one or more bus connectors configured to removably couple with the one or more electrical buses;
a structural printed circuit board assembly (PCBA) mounted in the casing, wherein the structural PCBA is configured to provide mechanical support and electrical connectivity for an industrial device, the structural PCBA comprising:
a rear surface electrically coupled to the one or more bus connectors to receive one or both of power and communications from the one or more electrical buses;
a front surface comprising one or more PCBA connectors; and
the industrial device mounted to the front surface such that the structural PCBA supports a weight of the industrial device, the industrial device comprising one or more device connectors electrically coupled with the one or more PCBA connectors.

2. The industrial automation system of claim 1, wherein:
the industrial device is a first industrial device;
the industrial unit further comprises a second industrial device mounted to the front surface of the structural PCBA such that the structural PCBA supports a weight of the second industrial device and provides electrical connectivity for the second industrial device; and
the structural PCBA further includes one or more traces electrically coupling the first industrial device to the second industrial device.

3. The industrial automation system of one of claims 1 or 2, wherein:
the industrial unit further comprises:
one or more unit busbars extending between the rear surface of the structural PCBA and the rear portion of the casing, the one or more unit busbars configured to electrically couple the one or more bus connectors to the structural PCBA; and
the industrial device plugs directly into the structural PCBA to receive one or both of power and communications from the one or more electrical buses via the one or more unit busbars and the structural PCBA, thereby electrically coupling the industrial device to the one or more electrical buses without flexible cables.

4. The industrial automation system of one of claims 1 to 3, wherein:
the one or more electrical buses comprise three electrical buses configured to supply three-phase electrical power; and
the one or more bus connectors comprise three plug-in connectors each configured to couple to a respective electrical bus of the three electrical buses.

5. The industrial automation system of one of claims 1 to 4, wherein the one or more device connectors are configured to directly contact the front surface of the structural PCBA to electrically couple the industrial device to the one or more PCBA connectors.

6. The industrial automation system of claim 5, wherein the one or more device connectors are electrically coupled to the one or more PCBA connectors via a soldered connection.

7. The industrial automation system of claim 5, wherein the one or more device connectors are electrically coupled to the one or more PCBA connectors via a compression fit connection.

8. The industrial automation system of one of claims 1 to 7, wherein:
the one or more device connectors are disposed on a lateral side of the industrial device; and
the industrial device comprises one or more device busbars configured to extend from the one or more device connectors to the one or more PCBA connectors to electrically couple the industrial device to the structural PCBA.

9. The industrial automation system of one of claims 1 to 8, wherein the structural PCBA comprises one of: a metal-core PCB, a heavy-copper-plate PCB, and an embedded coined PCB.

10. The industrial automation system of one of claims 1 to 9, wherein the industrial device is removably mounted to the structural PCBA.

11. The industrial automation system of one of claims 1 to 10, wherein the industrial device comprises one of: a contactor, a circuit breaker, a fused disconnect, a relay, motor starter, a motor drive, or a control component, or
wherein the industrial automation system comprises one of: a Motor Control Center (MCC), a power distribution board, or a load center.

12. An industrial unit configured to removably couple within an industrial control system cabinet, the industrial unit comprising:
a casing comprising a rear portion having one or more bus connectors configured to removably couple with one or more electrical buses of the industrial control system cabinet;
a structural printed circuit board assembly (PCBA) mounted in the casing, wherein the structural PCBA is configured to provide mechanical support and electrical connectivity for an industrial device, the structural PCBA comprising:
a rear surface electrically coupled to the one or more bus connectors to receive one or both of power and communications from the one or more electrical buses;
a front surface comprising one or more PCBA connectors; and
the industrial device mounted to the front surface such that the structural PCBA supports a weight of the industrial device, the industrial device comprising one or more device connectors electrically coupled with the one or more PCBA connectors.

13. The industrial unit of claim 12, further comprising:
one or more unit busbars extending between the rear surface of the structural PCBA and the rear portion of the casing, the one or more unit busbars configured to electrically couple the one or more bus connectors to the structural PCBA, wherein:
the industrial device plugs directly into the structural PCBA to receive one or both of power and communications from the one or more electrical buses via the one or more unit busbars and the structural PCBA, thereby electrically coupling the industrial device to the one or more electrical buses without flexible cables.

14. The industrial unit of one of claims 12 or 13, wherein the one or more device connectors are configured to directly contact the front surface of the structural PCBA to electrically couple the industrial device to the one or more PCBA connectors, and/or
wherein the one or more device connectors are electrically coupled to the one or more PCBA connectors via a soldered connection, or
wherein the one or more device connectors are electrically coupled to the one or more PCBA connectors via a compression fit connection.

15. The industrial unit of one of claims 12, to 14 wherein:
the one or more device connectors are disposed on a lateral side of the industrial device; and
the industrial device comprises one or more device busbars configured to extend from the one or more device connectors to the one or more PCBA connectors to electrically couple the industrial device to the structural PCBA, or
wherein the structural PCBA comprises one of: a metal-core PCB, a heavy-copper-plate PCB, and an embedded coined PCB, or
wherein the industrial device is removably mounted to the structural PCBA.
